# EUROPEAN PATENT APPLICATION

(11) **EP 4 576 471 A1**
(43) Date of publication of application: **25.06.2025**
(21) Application number: 23864380.3
(22) Date of filing: 05.06.2023
(51) Int. Cl.: H02J 1/08, H02J 1/10

(54) **POWER SUPPLY MODULE AND POWER SUPPLY METHOD**

(30) Priority: 15.09.2022 CN 202211130470
(71) Applicant: xFusion Digital Technologies Co., Ltd., Zhengzhou, Henan 450000 (CN)
(72) Inventor: LIU, Zao, Zhengzhou, Henan 450000 (CN)
(74) Representative: MERH-IP Matias Erny Reichl Hoffmann Patentanwälte PartG mbB
(86) International application number: PCT/CN2023/098411
(87) International publication number: WO 2024/055641

(57) **Abstract**

Disclosed are a power module assembly and a power supply method. The power module assembly includes (n+1) power modules and 2(n+1) input connectors, where n is a positive integer. The input connectors are used for connect power supply sources and the power modules. Each power module is connected to two input connectors. Based on positions of the 2(n+1) input connectors, when 2n input connectors among the 2(n+1) input connectors are connected to power supply inputs of the power supply sources and a (2a+1)th input connector and a (2a+2)th input connector among the 2(n+1) input connectors are not connected to the power supply inputs of the power supply sources, the (n+1) power modules in the power module assembly supply power to a load, where a is a non-negative integer, and is less than or equal to n. The power modules may be flexibly compatible with power supply inputs from 2(n+1) or 2n branches. In a case that the power supply inputs from the 2n branches are adopted, the (2a+1)th input connector and the (2a+2)th input connector are not connected to the power supply sources, reducing connection interfaces without affecting normal power supply.

## Description

The present application claims priority to Chinese Patent Application No. 202211130470.0, filed with the China National Intellectual Property Administration on September 15, 2022 and entitled "POWER MODULE ASSEMBLY AND POWER SUPPLY METHOD", which is incorporated herein by reference in its entirety.

### TECHNICAL FIELD

The present application relates to the field of power supplies, and in particular, to a power module assembly and a power supply method.

### BACKGROUND

As computing technology develops, a data center becomes increasingly large in scale, and an enterprise needs a power supply system with higher density, lower cost and improved energy efficiency. In many application fields, a large-scale computing device is needed to perform operations such as data storage, data exchange, and data computing to implement corresponding functions. A place where the large-scale computing device is placed and managed is generally referred to as a data center or computer room. A power supply of the computing device supplies power to a load of the computing device, to ensure normal operation of the load. An existing computing device generally adopts a redundant power supply, to improve reliability of the computing device and ensure normal power supply to the computing device.

Generally, a configuration of each data center is specific. Due to specific systems and components, a computing device that the data center can accommodate is fixed. It is time-consuming and costly to change a configuration of a specific computing device group.

### SUMMARY

The present application provides a power module assembly and a power supply method, which are compatible with power supply inputs from 2(n+1) branches and 2n branches. When receiving the power supply inputs from the 2(n+1) branches, (n+1) power modules in the power module assembly may supply power. When receiving the power supply inputs from the 2n branches, the (n+1) power modules in the power module assembly may still supply power. In a case that a configuration of an existing data center does not support, for example, there are not sufficient connectors for connecting power supply sources and remote power panels (RRPs), and a computer room needs to be reconstructed, the power supply inputs from the 2n branches may be adopted to save connectors for connecting the power supply sources and the RPPs and avoid computer room reconstruction.

According to a first aspect, the embodiment of the present application provides a power module assembly. The power module assembly includes (n+1) power modules and 2(n+1) input connectors: the input connectors used for connecting power supply sources and the power modules, each of the power module includes a first input port and a second input port which are respectively connected to an input connector; where n is a positive integer; based on positions of the 2(n+1) input connectors, when 2n input connectors among the 2(n+1) input connectors are connected to the power supply input of the power supply sources, and the (2a+1)th input connector and the (2a+2)th input connector among the 2(n+1) input connectors are not connected to the power supply input of the power supply sources, the (n+1) power modules among the power module assembly achieve power supply, where a is a non-negative integer, and a is less than or equal to n.

The power module assembly in the embodiment of the present application is configured as n+1 power modules, and the power modules which may be flexibly compatible with power supply inputs from 2(n+1) branches and power supply inputs from 2n branches. In this way, in a case that a configuration of an existing data center supports the method of power supply through 2(n+1) branches, for example, there are sufficient interfaces of power supply sources and remote power panel (RPP), the method of power supply through 2(n+1) branches may be adopted. In the case that the configuration of the existing data center does not support the method of power supply through 2(n+1) branches, for example, there are not sufficient interfaces of power supply sources and remote power panel (RPP), and the computer room needs to be reconstructed, the method of power supply through 2n branches may be adopted. The (2a+1)th and (2a+2)th input connectors are not connected to the power supply input, saving interfaces of the power supply sources and remote power panel. In this way, reconstruction of the computer room is avoided and the normal power supply is not affected.

A position based on the 2(n+1) input connectors is to illustrate a position order of the (2a+1)th input connector and the (2a+2)th input connector among the 2(n+1) input connectors, and the (2a+1)th input connector and the (2a+2)th input connector are two adjacent input connectors. For example, when the 2(n+1) input connectors are placed in a row/column, the (2a+1)th input connector and the (2a+2)th input connector may be identified in an order from left to right/top to bottom. When the 2(n+1) input connectors are placed in two rows, the (2a+1)th input connector and the (2a+2)th input connector may be identified in an order from left to right and then from top to bottom, that is, the (2a+1)th input connector and the (2a+2)th input connector may be identified in an order of a first in the first row and a second in the first row. When the 2(n+1) input connectors are placed in two areas, the (2a+1)th input connector and the (2a+2)th input connector may be identified in the order of the first in the first area and the second in the first area. The specific orders will not be listed one by one here.

In combination with the first aspect, in a possible implementation, the (n+1) power modules include a first power module and a second power module, where a first input port of the first power module is connected to a (2b+1)th input connector, a second input port of the first power module is connected to the (2a+1)th input connector, a first input port of the second power module is connected to a (2b+2)th input connector, and a second input port of the second power module is connected to the (2a+2)th input connector, where b is a non-negative integer, and is less than or equal to n, and b is not equal to a.

In a possible implementation, when 2n input connectors among the 2(n+1) input connectors are connected to the power supply input of power supply sources, the (2a+1)th input connector and the (2a+2)th input connector among the 2(n+1) input connectors are not connected to the power supply input of power supply sources, the first power module and the second power module receive power from one power supply input of power supply sources respectively and achieve power supply; among the (n+1) power modules, except for the first power module and the second power module, remaining (n-1) power modules receive two power supply inputs of the power supply sources and achieve power supply.

In such connection mode, the (2a+1)th input connector and the (2a+2)th input connector are not connected to the power supply sources. However, because the (n+1) power modules in the power module assembly are dual-input power modules and the (2a+1)th input connector and the (2a+2)th input connector are connected to two power modules respectively, that are, the first power module and the second power module, the first power module and the second power module receive power from one input respectively. Generally, for a dual input power module, when the dual-input power module only receives power from one input, an alarm is generated indicating that the power supply is abnormal. Therefore, the first power module and the second power module in the power module assembly in the embodiment of the present application provides may be compatible with receiving dual input power supply and single input power supply. When either of the two power modules receives power from only one input, no alarm is generated and power is supplied to the load normally.

Optionally, the power module assembly includes 2(n+1) input connectors, each two input connectors forming a group. The (2a+1)th input connector and the (2a+2)th input connector may be a last group of input connectors (that is, the (2a+1)th input connector and the (2a+2)th input connector are last two input connectors) or any group of input connectors.

In combination with the first aspect, in a possible implementation, among the 2(n+1) input connectors, excluding the (2a+1)th input connector and the (2a+2)th input connector, all odd-numbered input connectors are connected to one power supply input of the power supply sources, and all even-numbered input connectors are connected to the other power supply input of the power supply sources. When the one power supply input which is connected to all the odd-numbered input connectors fails, the other one power supply input supplies power to the n power modules which are connected the all even-numbered connectors, the n power modules include remaining power modules among the (n+1) power modules that except the first power module. Or, when the one power supply input which is connected to all the even-numbered input connectors fails, the other one power supplies power to the n power modules which are connected to all the odd-numbered connectors, the n power modules include remaining power modules among the (n+1) power modules that except the second power module. Or, when one of the (n+1) power modules fails, remaining n power modules supply power.

In combination with the first aspect, in a possible implementation, the (2a+1)th input connector and the (2a+2)th input connector are expansion input connectors, among the 2(n+1) input connectors except the(2a+1)th input connector and the (2a+2)th input connector, remaining (2n-2) input connectors are non-expansion input connectors, and the expansion input connectors and non-expansion input connectors have different identifiers.

The fixed input connectors and the expansion input connectors may be easily distinguished. For example, the fixed input connector and the expansion input connector may have different types of interfaces, or the fixed input connector and the expansion input connector may be made from different materials, or the fixed input connector and the expansion input connector may have different identifiers. For example, the expansion input connectors may have special identifiers, for example, ports of expansion input connectors may be marked by dashed boxes. For another example, an identifier of a fixed input connector or an identifier of an expansion input connector are noted in related operation instructions.

In combination with the first aspect, in a possible implementation, the input connectors and power modules are connected by a printed circuit board and/or a backplane. The connection method may incThe input connectors and power modules are independent of each other, and may be connected by the cables, copper bars, or the like. Optionally, the input connectors and the power modules may also be connected through a PCB, with one end of the PCB being connected to the power module assembly based on plugs, cables, or the like, and the other end of the PCB being connected to the input connectors through plugs, cables, or the like. Optionally, the input connectors may also be connected to the backplane through cables, copper bars, or the like, with one end of the PCB being connected to the backplane, and the other end of the PCB being connected to the input connectors through plugs, cables, or the like. The input connectors are connected to the power module assembly based on the PCB board and the backplane. Optionally, the input connectors and the power modules may also be connected by the backplane, with one end of the backplane being connected to the power module assembly through plugs, cables, or the like, the other end of the backplane being connected to the input connectors through plugs, cables, or the like, the input connectors being connected to the power module assembly based on the backplane

In combination with the first aspect, in a possible implementation, a is equal to n. Based on positions of the (n+1) power modules and the 2(n+1) input connectors, a first input port of an nth power module is connected to a (2n-1)th input connector, a second input port of the nth power module is connected to the (2n+1)th input connector, a first input port of an (n+1)th power module is connected to a (2n)th connector, and a second input port of the (n+1)th power module is connected to a (2n+2)th input connector.

According to the practices of common interface in the industry, the input connectors are connected sequentially. Therefore, the last group of input connectors, that are, last two input connectors are used as expansion input connectors, and the last two power modules are used as power modules that receive power from one input respectively. A most possible connection mode is provided, which fully adapts to users' ways of connecting interfaces and is universally applicable to practical applications.

In a second aspect, the embodiment of the present application provides a power supply method. The power supply method includes: a power module assembly receives two power supply inputs from power supply sources; the power module assembly supplies power to a load based on a dual-input power module, where the power module assembly includes (n+1) power modules and 2(n+1) input connectors; the input connectors are used for connecting the power supply sources and power modules, each of the power modules includes a first input port and a second input port which are respectively connected to one input connector; where n is a positive integer; and the (n+1) power modules in the power module assembly supply power when 2n input connectors among the 2(n+1) input connectors are connected to a power supply input of the power supply sources, and a (2a+1)th input connector and a (2a+2)th input connector among the 2(n+1) input connectors are not connected to the power supply input of the power supply sources based on positions of the 2(n+1) input connectors, where a is a non-negative integer, and a is less than or equal to n.

The power supply method in the embodiment of the present application is configured as n+1 power modules, and the power modules which may be flexibly compatible with power supply inputs from 2(n+1) branches and power supply inputs from 2n branches. When the power module assembly receives the power supply inputs from 2n branches, the n+1 power modules among the power module assembly achieve power supply. In this way, in a case that the configuration of the existing data center supports the method of power supply through the 2(n+1) branches, for example, there are sufficient interfaces of power supply sources and remote power panels (RPPs), the method of power supply through 2(n+1) branches may be adopted. In a case that the configuration of the existing data center does not support the method of power supply through 2(n+1) branches, for example, there are not sufficient interfaces of power supply sources and remote power panels (RPPs), and the computer room needs to be reconstructed, the method of power supply through the 2n branches may be adopted. The (2a+1)th and (2a+2)th input connectors are not connected to the power supply input, saving interfaces of the power supply sources and the remote power panels. In this way, reconstruction of the computer room is avoided and normal power supply is not affected.

In combination with the second aspect, in a possible implementation, each of the (n+1) power modules includes a first power module and a second power module, where the first input port of the first power module is connected to the (2b+1)th input connector, the second input port of the first power module is connected to the (2a+1)th input connector, the first input port of the second power module is connected to the (2b+2)th input connector, and the second input port of the second power module is connected to the (2a+2)th input connector, where b is a non-negative integer, and is less than or equal to n, and b is not equal to a.

In a possible implementation, when 2n input connectors among the 2(n+1) input connectors are connected to the power supply input of power supply sources , the (2a+1)th input connector and the (2a+2)th input connector among the 2(n+1) input connectors are not connected to the power supply input of power supply sources, the first power module and the second power module receive power from one input of power supply sources respectively and achieve power supply; among the (n+1) power modules, except for the first power module and the second power module, the remaining (n-1) power modules receive two power supply inputs of the power supply sources and achieve power supply.

In such connection mode, the (2a+1)th input connector and the (2a+2)th input connector are not connected to the power supply sources. However, because the (n+1) power modules in the power module assembly are dual-input power modules and the (2a+1)th input connector and the (2a+2)th input connector are connected to two power modules respectively, that are, the first power module and the second power module, the first power module and the second power module receive power from on input respectively. Generally, for the dual-input power module, when the dual-input power module only receives power from one input, an alarm is generated indicating that the power supply is abnormal. Therefore, the first power module and the second power module in the power module assembly in the embodiment of the present application provides may be compatible with receiving dual input power supply and single input power supply. When either of the two power modules receives power from only one input, no alarm is generated and power is supplied to loads normally.

Optionally, the power module assembly includes 2(n+1) input connectors, each two input connectors forming a group. The (2a+1)th input connector and the (2a+2)th input connector may be a last group of input connectors (that is, the (2a+1)th input connector and the (2a+2)th input connector are last two input connectors) or any group of input connectors.

In combination with the first aspect, in a possible implementation, among the 2(n+1) input connectors, excluding the (2a+1)th input connector and the (2a+2)th input connector, all odd-numbered input connectors are connected to one power supply input of the power supply sources and all even-numbered input connectors are connected to the other power supply input of the power supply sources. When the one power supply input which is connected to all the odd-numbered input connectors fails, the other one power supply input supplies power to the n power modules to which all the even-numbered connectors are connected, the n power modules include remaining power modules among the (n+1) power modules that except the first power module. Or, when the one power supply input which is connected to all the even-numbered input connectors fails, the other one power supply input supplies power to the n power modules to which all the odd-numbered connectors are connected, the n power modules include remaining power modules among the (n+1) power modules that except the second power module. Or, when one of the (n+1) power modules fails, remaining n power modules supply power.

In a third aspect, the embodiment of the present application provides a computing device, including a power module assembly and a load; the power module assembly is used for supplying power to the load based on a dual-input power supply inputs; the power module assembly includes (n+1) power modules and 2(n+1) input connectors, the input connectors used for connecting power supply sources and the power modules, each power module includes a first input port and a second input port which are respectively connected to an input connector; where n is a positive integer; based on positions of the 2(n+1) input connectors, when 2n input connectors among the 2(n+1) input connectors are connected to the power supply input of the power supply sources, and the (2a+1)th input connector and the (2a+2)th input connector among the 2(n+1) input connectors are not connected to the power supply input of the power supply sources, the (n+1) power modules among the power module assembly achieve power supply, where a represents a non-negative integer, and is less than or equal to n.

The load includes electronic components and the like that need to be powered in a computing device, for example, processors, memories, and chips.

In combination with the third aspect, in a possible implementation, each of the (n+1) power modules include a first power module and a second power module, where a first input port of the first power module is connected to a (2b+1)th input connector, a second input port of the first power module is connected to a (2a+1)th input connector, a first input port of the second power module is connected to a (2b+2)th input connector, and a second input port of the second power module is connected to the (2a+2)th input connector, where b is a non-negative integer, and is less than or equal to n, and b is not equal to a.

In a possible implementation, when 2n input connectors among the 2(n+1) input connectors are connected to the power supply input of power supply sources, the (2a+1)th input connector and the (2a+2)th input connector among the 2(n+1) input connectors are not connected to the power supply input of power supply sources, the first power module and the second power module receive power from one power supply input of power supply sources respectively and achieve power supply; among the (n+1) power modules, except for the first power module and the second power module, remaining (n-1) power modules receive two power supply inputs of the power supply sources and achieve power supply.

In such connection mode, the (2a+1)th input connector and the (2a+2)th input connector are not connected to power supply sources. However, because the (n+1) power modules in the power module assembly are dual-input power modules and the (2a+1)th input connector and the (2a+2)th input connector are connected to two power modules respectively, that are, the first power module and the second power module, the first power module and the second power module receive power from one input respectively. Generally, for a dual input power module, when the dual-input power module only receives power from one input, an alarm is generated indicating that the power supply is abnormal. Therefore, the first power module and the second power module in the power module assembly provided in the embodiment of the present application may be compatible with receiving dual input power supply and single input power supply. When either of the two power modules receives power from only one input, no alarm is generated and power is supplied to the load normally.

Optionally, the power module assembly includes 2(n+1) input connectors, each two input connectors forming a group. The (2a+1)th input connector and the (2a+2)th input connector may be a last group of input connectors (that is, the (2a+1)th input connector and the (2a+2)th input connector are last two input connectors) or any group of input connectors.

In combination with the third aspect, in a possible implementation, among the 2(n+1) input connectors, excluding the (2a+1)th input connector and the (2a+2)th input connector, all odd-numbered input connectors are connected to one power supply input of power supply sources and all even-numbered input connectors are connected to the other power supply input of power supply sources. When the one power supply input which is connected to all the odd-numbered input connectors are fails, the other one power supply input supplies power to the n power modules which are connected to all the even-numbered connectors, the n power modules include remaining power modules among the (n+1) power modules that except the first power module. Or, when the one power supply input which are connected to all the even-numbered input connectors are fails, the other one power supply input supplies power to the n power modules which are connected to all the odd-numbered connectors, and the n power modules include remaining power modules among the (n+1) power modules that except the second power module. Or, when one of the (n+1) power modules fails, remaining n power modules supply power. In combination with the third aspect, in a possible implementation, the power module assembly is connected to 2(n+1) input lines one by one based on 2(n+1) input connectors to receive a power supply input from power supply sources. The load includes a processing component. The processing component is used to detect, when the 2(n+1) input lines are present and power supply normally, and the first input port and the second input port of the (n+1) power modules have the power supply input respectively, determining the power module assembly is in a normal power supply status. The processing component in the computing device may be a component that has data processing capabilities such as a central processing unit (CPU) and an out-of-band controller. That the power module assembly is in the normal power supply status indicates that the power modules in the power module assembly may receive power and supply power to the load in a stable manner. In such implementation mode, when each of the (n+1) power modules in the power module assembly receives power from two power supply inputs, it is considered that the power module assembly is in the normal power supply status.

In combination with the third aspect, in a possible implementation, the power module assembly is connected to 2n input lines one by one based on the 2n input connectors among the 2(n+1) input connectors to receive a power supply input from the power supply sources. The load include a processing component. The processing component is used to detect, when the 2n input lines are present and power supply normally, and the first input port and the second input port of (n-1) power modules among the (n+1) power modules have a power supply input respectively, and one input port of two power modules among the (n+1) power modules can receive a power supply input, determining the power module assembly is in a normal power supply status. Generally, for a dual input power module, when the dual-input power module only receives power from one power supply input, an alarm is generated indicating that the power supply is abnormal. In such implementation mode, two power modules in the power module assembly may be compatible with receiving dual-input power supply and single-input power supply, that is, when the two power modules only receive one power supply, no alarm is generated and the two power modules supply power to the load normally. In this case, the power module assembly is considered to be in a normal power supply status.

Optionally, the computing device records identifiers of two power modules in the power module assembly, which may be compatible with receiving dual-input power supply and single-input power supply. The processing component is used for detecting, when the two power modules receive power from only one power supply input respectively, and first input ports and second input ports of the other (n-1) power modules except for the two power modules have the power supply input, determining the power module assembly is in a normal power supply status.

Optionally, the computing device records identifiers of two power modules in the power module assembly, which may be compatible with receiving dual-input power supply and single-input power supply. The processing component is used for detecting, when the two power modules receive power from only one power supply input respectively, and one power module receives power from one power supply input of the power supply sources and the other power module receives power from the other power supply input of the power supply sources, except for the two power modules, the first input ports and the second input ports of the other (n-1) power modules have the power supply input, determining the power module assembly is in a normal power supply status.

In a fourth aspect, the embodiment of the present application provides a server cabinet, and the server cabinet includes a cabinet body, a power module assembly, and a load; the power module assembly and the load are installed in the cabinet body; and the cabinet body is connected to an external dual-input power supply sources, the power module assembly is used to supply power to the load based on the dual power supply input; the power module assembly includes (n+1) power modules and 2(n+1) input connectors: the input connectors used for connecting power supply sources and the power module, each power module includes a first input port and a second input port which are respectively connected to one input connector; where n is a positive integer; based on positions of the 2(n+1) input connectors, when 2n input connectors among the 2(n+1) input connectors are connected to a power supply input of the power supply sources, and a (2a+1)th input connector and a (2a+2)th input connector among the 2(n+1) input connectors are not connected to the power supply input of the power supply sources, the (n+1) power modules among the power module assembly achieve power supply, where a is a non-negative integer, and is less than or equal to n. For related description of the power supply assembly, refer to the foregoing first aspect, second aspect, or third aspect. Details are not described herein again.

### BRIEF DESCRIPTION OF DRAWINGS

In order to more clearly illustrate the technical solutions of embodiments of the present application or of the related art, the following description will briefly introduce the drawings that need to be used in descriptions of the embodiments or the related art. It is obvious that the drawings in the following description are only some embodiments of the present application, and other drawings may be obtained according to these drawings without inventive effort for those skilled in the art.
FIG. 1 is a schematic structural diagram of a data center according to an embodiment of the present application;
FIG. 2 is a structural frame diagram of a computer rack according to an embodiment of the present application;
FIG. 3 is a schematic structural diagram of a power module configuration form according to an embodiment of the present application;
FIG. 4 is a schematic structural diagram of another power module configuration form according to an embodiment of the present application;
FIG. 5 is a structural frame diagram of a server according to an embodiment of the present application;
FIG. 6 is an architecture diagram of a power module assembly according to an embodiment of the present application;
FIG. 7 is a schematic structural diagram of a power module assembly according to an embodiment of the present application;
FIG. 8 is a schematic structural diagram of a two-way changeover switch in a power module assembly according to an embodiment of the present application;
FIG. 9 is a schematic diagram of a connection mode of a power module assembly and an input connector according to an embodiment of the present application;
FIG. 10 is a schematic diagram of another connection mode of a power module assembly and an input connector according to an embodiment of the present application;
FIG. 11 is a schematic diagram of another connection mode of a power module assembly and an input connector according to an embodiment of the present application;
FIG. 12 is a schematic diagram of another connection mode of a power module assembly and an input connector according to an embodiment of the present application;
FIG. 13 is a schematic diagram of another connection mode of a power module assembly and an input connector according to an embodiment of the present application;
FIG. 14 is a schematic diagram of a connection mode of a power supply source and an input connector according to an embodiment of the present application;
FIG. 15 is a schematic diagram of another connection mode of a power module assembly and an input connector according to an embodiment of the present application;
FIG. 16 is a schematic diagram of another connection mode of a power module assembly and an input connector according to an embodiment of the present application; and
FIG. 17 is a schematic structural diagram of an electronic device according to an embodiment of the present application.

### DESCRIPTION OF EMBODIMENTS

The following describes the embodiments of the present application with reference to drawings in the embodiments of the present application.

Terms such as "first", "second", "third", and "fourth" in the description, claims, and drawings of the present application are used to distinguish different items, rather than to describe a particular order. Furthermore, the terms "comprise" and "have" or any other variation thereof, are intended to cover a non-exclusive inclusion. For example, processes, methods, systems, products, or devices including a series of steps or units is not limited to the listed steps or units, but optionally includes unlisted steps or units, or optionally further includes other steps or units inherent in these processes, methods, products, or devices.

Terms used in the description such as "component", "module", and "system" are intended to represent a computer-related entity, hardware, firmware, a combination of hardware and software, software, or software in execution. For example, a component may be, but is not limited to being, a process running on a processor, a processor, an object, an executable file, a thread of execution, a program, and/or a computer. By way of illustration, both an application running on a terminal and the terminal can be components. One or more components may reside within a process and/or thread of execution and a component may be located on one computer and/or distributed between two or more computers. Furthermore, these components can be executed from various computer readable media that have various data structures stored thereon. The components can communicate with each other through local and/or remote processes based on a signal that has one or more data packets (for example, data from two components that interact with another component in a local system, distributed system, and/or across a network such as the Internet that interacts with other systems via the signal).

Currently, in many application fields, a large-scale computing device is needed to perform operations such as data storage, data exchange and data computing to implement relevant functions.

A place where the large-scale computing device is placed and managed is generally referred to as a data center or computer room. Specifically, the data center may be a center that provides information technology (IT) application services such as data computing, network transmission and data storage. The data center may have a series of environmental conditions such as high-speed and reliable internal and external network environments, systematic monitoring support means, and large-scale sites and computer room facilities. Furthermore, the data center may realize unified management of IT infrastructure, business applications, and data.

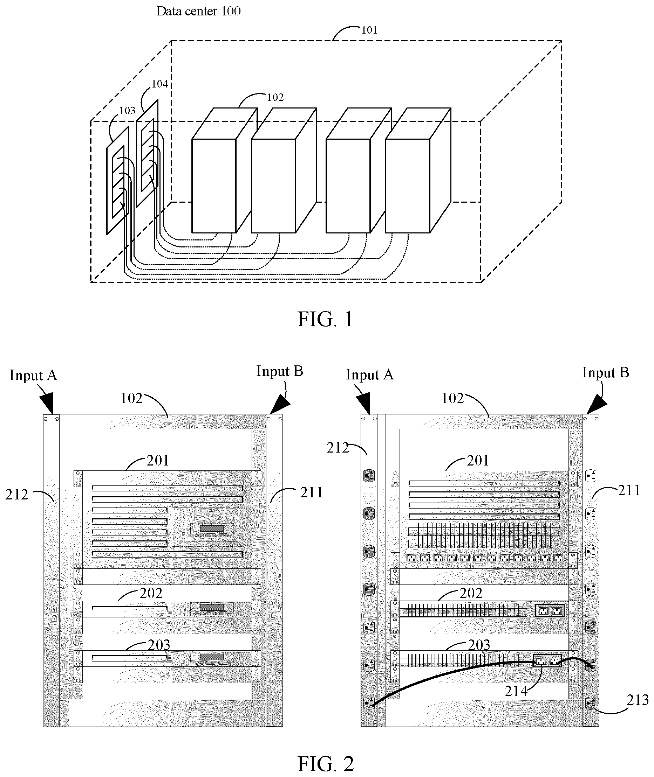

As shown in FIG. 1, FIG. 1 shows a data center 100. The data center 100 includes a computer room 101, one or more computer racks 102, a power supply source 103, and a power supply source 104. A plurality of computing devices/network devices such as servers and switches may be placed in the one or more computer racks 102. The power supply source 103 or the power supply source 104 is used to supply power to the computing devices placed in the one or more computer racks 102. By way of example, the power supply source 103 or the power supply source 104 may provide alternating current (AC) and/or direct current (DC).

In some embodiments, the power supply source 103 and the power supply source 104 are two independent inputs and each computer rack 102 may receive one or two power supply inputs.

In some embodiments, a power supply system of the data center 100 shown in FIG. 1 may be a 2n system (also referred to as an n+n system), where n represents mains. That is, the power supply source 103 and the power supply source 104 provide two independent mains. The power supply source 103 and the power supply source 104 may be respectively referred to as a primary electrical power system (an active power supply input) and a secondary electrical power system (a backup power supply input). Both the power supply source 103 and the power supply source 104 are connected to the computing devices. When one of the power supply source 103 or the power supply source 104 fails, the computing devices may automatically switch to the other power supply source to maintain uninterrupted power supply. In this way, stability of power supply to the data center 100 is improved. In an embodiment of the present application, two power supply inputs provided by the power supply source 103 and the power supply source 104 may be respectively referred to as input A and input B.

In some embodiments, the power supply system of the data center 100 may also be an n+1 system which includes a mains power supply plus a generator, that is, two power supply sources are connected to the computing devices. In some embodiments, the power supply system of the data center 100 may also be a 2n+1 system which includes two mains plus a generator as a backup, that is, two power supply sources are connected to the computing devices and the generator is used as backup power supply sources.

The following describes a specific structure configuration of a computer rack by taking the computer rack 102 in the data center 100 for example. As shown in FIG. 2, FIG. 2 shows a front view (left) and a rear view (right) of the computer rack 102. By way of example, as shown in FIG. 2, three servers are placed in the computer rack 102, which are a server 201, a server 202, and a server 203 respectively. The computer rack 102 is configured with a remote power panel (RPP) 211 and a RPP 212, which are respectively connected to one power supply input. The RPP 211 and the RPP 212 are installed near an electrical device to supply power to the electrical device (such as the server 201, the server 202, and the server 203). In combination with FIG. 1, it can be seen that the power supply source 103 and the power supply source 104 are respectively connected to two RPPs of each computer rack 102 to provide two power supply inputs for each computer rack 102. By way of example, as shown in FIG. 2, the input A (the power supply source 103) is connected to the RPP 212 and the input B (the power supply source 104) is connected to the RPP 211.

The RPP 211 and the RPP 212 shown in FIG. 2 each are configured with 7 power supply interfaces 213, and are used to be connected to the electrical device.

Each server has a plurality of power interfaces 214. For example, in FIG. 2, the server 201 includes 12 power interfaces 214, and the server 202 and the server 203 each have 2 power interfaces 214. After the power interfaces 214 and the power supply interfaces 213 are connected, the server is electrically connected to the power supply source.

In an embodiment of the present application, the power interfaces 214 may also be referred to as input connectors. The input connectors are used to electrically connect the power modules to the power supply sources.

In some embodiments, the server supports various types of power configurations. For example:

Configuration 1: n power configuration, indicating that the server can work properly with n power modules, and is configured with the n power modules but no backup power module. If 1 power module fails, remaining n-1 power modules cannot supply sufficient power to the server, thereby affecting services, so that power supply reliability cannot be guaranteed.

By way of example, the server 202 and the server 203 each are in the form of n power configuration (n=1), where 2 power interfaces are two interfaces of 1 power module. That is, a power type of the power module is a dual-input power supply. As shown in FIG. 2, the 2 power interfaces of the server 202 (or the server 203) are framed together, indicating that the 2 power interfaces are power interfaces of a same power module.

Configuration 2: n+n power configuration, indicating that the server can work properly with n power modules but is configured with 2n power modules among which n power modules are used as redundant power backups. The data center provides two power supply inputs for the server. Each of the two power supply inputs is connected to the n power modules. If one power supply input fails, the other power supply input can provide power needed for normal operation of the server. In this case, each power module is connected to one power supply input, and a power type of the power module may be a single-input power module.

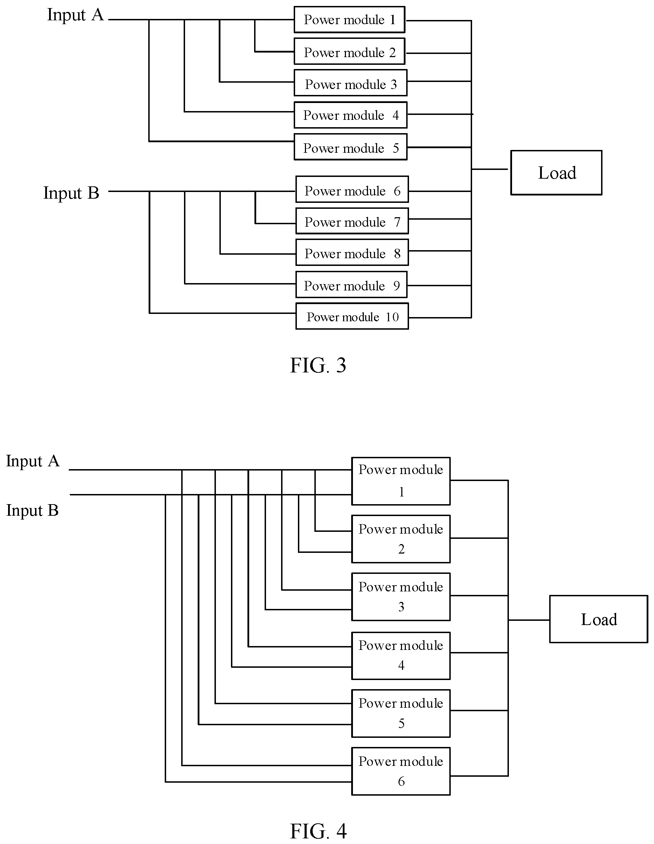

By way of example, in FIG. 3, FIG. 3 shows a 5+5 power configuration, 5 power modules are used as backup power modules. The power of the server is 15 kW and the power of each power module is 3 kW. The data center provides input A with 5 branches and input B with 5 branches. A total of 10 branches correspond to each power module, and the input A and the input B are independent of each other. If input A fails, input B can supply 3 kw x 5 = 15 kw power to the server. If one of the 10 power modules fails, remaining 9 power modules can supply 3 kW x 9 = 27 kW power to the server. If input A or input B fails or one of the 10 power modules fails, services are not affected and power supply reliability can be guaranteed.

However, in the configuration 2, maximum 3 kw x 10=30 kw power can be theoretically supplied to the server in a case that the input does not fail. However, the power of the server is only 15 kw. Therefore, there is a huge waste of cost. Furthermore, more internal space of the server is occupied, which affects the internal spatial density of the server.

Configuration 3: n+1 power configuration, indicating that the server can work properly with n power modules but is configured with n+1 power modules among which one power module is used as a redundant power backup. The data center supplies two power supply inputs. Each of the two power supply inputs is connected to n+1 power modules. If one power supply input fails, the other power supply input can provide power needed for normal operation. In this case, each power module needs to be connected to two power supply inputs, and the power type of each power module is a dual-input power supply.

By way of example, as shown in FIG. 4, FIG. 4 shows a 5+1 power configuration. That is, 1 power module is used as a backup. The power of the server is 15 kW and the power of each power module is 3 kW. The data center provides input A with 6 branches and input B with 6 branches. A total of 12 branches correspond to each power module. Input A and input B are independent of each other. If input A fails, input B may provide 3 kwx6=18 kw power for the server. If one power module fails, input A may provide 3 kwx5=15 kw power. If input A or input B fails or one of the 6 power modules fails, services are not affected and power supply reliability can be guaranteed. Furthermore, compared with the 5+5 power configuration, the configuration reduces a quantity of the power modules from 10 to 6, thereby reducing cost by 40% and greatly saving internal space of the server.

In actual applications, computer racks of some servers with high configuration requirements may receive 2n backup power modules, some computer racks may receive n+1 backup power modules, and some computer racks may receive parallel power modules from one or more individual power supply units. It is expensive and time-consuming to configure all racks for a specific type of power redundancy with the support of a specific electrical power system, since each configuration needs to establish a matched electrical power support redundancy for each computer rack based on specific configurations of specific upstream systems and components.

It can be seen that though the configuration 3 can provide same reliability by using fewer power modules than the configuration 2, the configuration 3 needs two more branches compared with the configuration 2. For example, in the 5+1 power configuration, 6 branches of input A and 6 branches of input B, 12 branches in total, are connected to corresponding power modules, that is, in the n+1 power configuration, inputs from 2(n+1) branches are needed. By contrast, in the 5+5 power configuration, 5 branches of input A and 5 branches of input B, 10 branches in total, are connected to corresponding power modules, that is, in the n+n power configuration, inputs from 2n branches are needed.

In some scenarios, in combination with FIG. 2, the computer rack 102 is configured with the RPP 211 and the RPP 212 of the dual-input power supply. The RPP 211 and the RPP 212 respectively provide 7 power interfaces. The server 202 includes two power interfaces that need to be connected to one power supply interface of the RPP 211 and one power supply interface of the RPP 212 respectively. The server 203 also includes 2 power interfaces that need to be connected to one power supply interface of the RPP 211 and one power supply interface of the RPP 212 respectively. The server 201 has 12 power interfaces that need to be connected to 6 power supply interfaces of the RPP 211 and 6 power supply interfaces of the RPP 212 respectively. However, the RPP 211 and the RPP 212 respectively have only 7 power supply interfaces. After being connected to the server 202 and the server 203, the RPP 211 and the RPP 212 each have only 5 power supply interfaces left to be connected to the server 201.

In this case, to make the server 201, the server 202, and the server 203 work normally, two RPPs need to be added to the computer rack 102 to provide one power supply interface for the server 201 respectively. The added two RPPs may have a low utilization rate because each RPP generally has more than one power supply interface. Furthermore, each RPP needs to be connected to one power supply input. For example, the RPP 212 is connected to input A (the power supply source 103) and the RPP 211 is connected to input B (the power supply source 104). If two RPPs are added, the two RPPs need to be respectively connected to the power supply source 103 or the power supply source 104. That is, the power supply source 103 and the power supply source 104 need to respectively provide one branch.

However, each data center 100 has a specific configuration. Due to a specific system and component of the data center, it may be time-consuming and costly to change a configuration of a specific computing device group, for example, to add a circuit and an interface of the power supply sources, to install a new RPP, to provide a circuit that connects the power supply source to the new RPP, and to add a circuit that connects the new RPP and the computing device. The change may involve adding or removing various systems and components, and may involve changes of the floor area, wall space and the like of the data center 100. Reconfiguration of various systems and components of the data center 100 may temporarily take some systems and components offline and even shut down the computing unit to achieve the change of the specific system and component, thereby increasing reconstruction cost.

The embodiment of the present application provides a power module assembly. The power module assembly is in the form of n+1 power configuration. The power module assembly may be flexibly compatible with power supply inputs from the 2(n+1) branches and the 2n branches. In this case, if the configuration of the existing data center supports the power supply inputs from the 2(n+1) branches, for example, if the RPPs have sufficient interfaces for connecting to the power supply sources, the power supply inputs from the 2(n+1) branches may be adopted. If the configuration of the existing data center does not support the power supply inputs from the 2(n+1) branches, for example, if the RPPs do not have sufficient interfaces for connecting to the power supply sources, and the computer room needs to be reconstructed, the power supply inputs from the 2n branches may be adopted, which saves RPP interfaces and avoids computer room reconstruction.

In addition, the power module assembly is available for any electronic device that needs power supply such as the server 201. As described above, the server 201 in FIG. 2 has 12 input connectors that need to be connected to 6 power supply interfaces of the RPP 211 and 6 power supply interfaces of the RPP 212 respectively. However, the RPP 211 and the RPP 212 respectively only have 7 power supply interfaces. After being connected to the server 202 and the server 203, the RPP 211 and the RPP 212 respectively have only 5 power supply interfaces left to be connected to the server 201. Based on the power module assembly provided in the embodiment of the present application, the server 201 only needs to be connected to the power supply interfaces so that the power module assembly may supply power to the server 201 in a reliable manner.

In the embodiment of the present application, the electronic device may be a computer device, a storage device, a wireless device, a network device, or the like. The embodiment of the present application takes the electronic device being the server 201 for example.

The following explains and describes the structure of the server 201 involved in the embodiment of the present application.

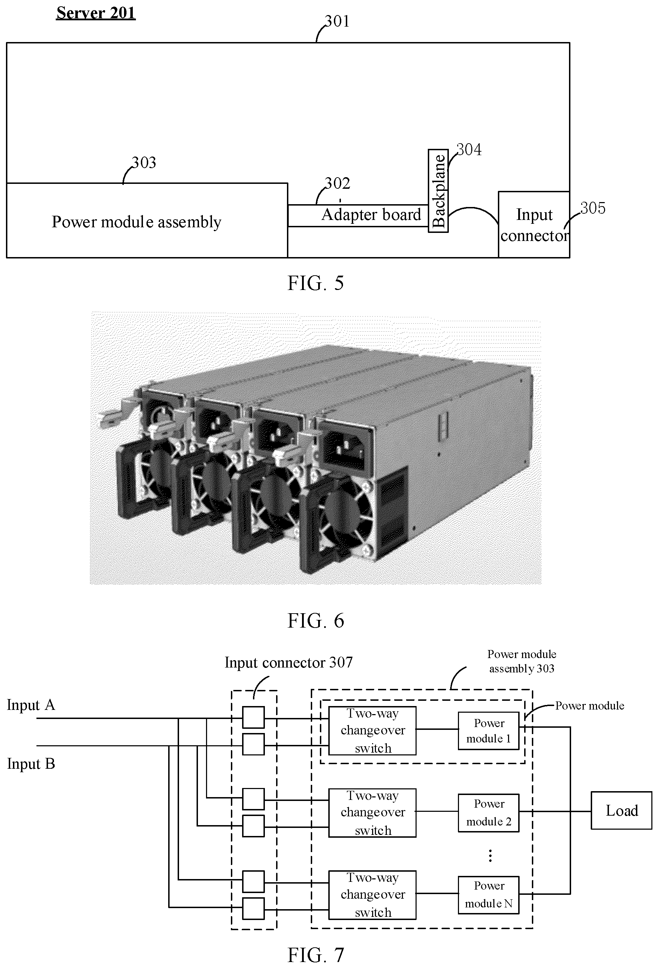

As shown in FIG. 5, FIG. 5 shows a structural diagram of the server 201. The server 201 includes a chassis 301 and an adapter board 302 placed in the chassis 301, a power module assembly 303, a backplane 304, an input connector 305, and various electronic devices (not shown in FIG. 5).

It should be noted that the structure shown in FIG. 5 does not constitute a specific limitation on the server 201. In other embodiments of the present application, the server 201 may include more or fewer components than those shown in the figure, or some components may be combined, or some components may be split, or different component arrangements. The components shown in the figure may be implemented by hardware, software, or a combination of software and hardware. By way of example, the server 201 also includes a fan module, a drive module, and other modules. The fan module may dissipate heat from heat sources such as CPUs, DIMMs, and drive modules in the server 201 and remove a large amount of heat in the chassis 301 in a timely manner, to ensure stable operation of the server 201. The drive modules feature good scalability and may provide an efficient storage resource for the server 201.

It may be understood that the chassis 301 features a shell structure with high strength, and is configured to protect internal components of the server 100. The various electronic devices in the server include but are not limited to central processing units (CPUs), DIMMs, universal serial buses (USBs), complex programmable logic devices (CPLDs), and flashes. A quantity of each type of electronic device may be one, two, three, or more, which is not limited here.

The adapter board 302 includes a power adapter board, and is a circuit board capable of transfering power from power interfaces. In some embodiments, the adapter board 302 is connected to the power module assembly 303. The adapter board 302 may be a printed circuit board (PCB) that is conducted in a direction perpendicular to the power module assembly 303, and pins corresponding to a plurality of power modules in the power module assembly 303 are inserted along a vertical line, to achieve connection between the power module assembly 303 and the adapter board. Optionally, a corresponding port may be inserted into a corresponding position of the PCB board (the adapter board 302), so that the port is connected to the plurality of power modules in the power module assembly 303. In this way, the adapter board 302 may be connected to the power module assembly 303.

In some embodiments, the adapter board 302 may have a daughter board, and allocate power to the daughter board to implement electrical connection and signal transmission. The daughter board may be inserted into or welded to the adapter board 302 or connected to the adapter board 302 by a cable. Optionally, the adapter board 302 is generally a printed circuit board (PCB) with a main circuit system of a computer mounted thereon. In addition, components such as a BIOS chip, an I/O control chip, a keyboard and a panel control switch interface, an indicator connector, an expansion slot, a mainboard and a DC power supply connector of an insert card may generally be mounted on the PCB. In the embodiment of the present application, the adapter board 302 is connected to the power module assembly 303 by insertion, a cable and other manners.

The backplane 304 is a mainboard that carries a daughter board or a line card, which may implement custom functions. The backplane 304 is used to support connection between other circuit boards and between components, and is a circuit board or hardware connection framework that provides power supply and data signals for supported components, so that the entire system operates logically. As shown in FIG. 5, the adapter board 302 is inserted into the backplane 304.

The power module assembly 303 may receive power from an external power supply source (not shown in FIG. 5) and supply power to electrical components such as CPUs, DIMMs, and USBs in the server 201 to implement an overall power supply structure of the server 201 and ensure long-term efficient operation of the server 201. The power module assembly 303 may be configured with one or more power modules based on power supply requirements.

The input connector 305 is used to connect the power module assembly 303 to the external power supply source and provide connection interfaces for the power module assembly 303 and the external power supply source. The input connector 305 may be configured with various types of connectors such as C13 and C19 connectors.

Optionally, the input connector 305 may be connected to the power module assembly 303 by a cable or copper bar. The input connector 305 is connected to the external power supply source and supplies power to the power module assembly 303.

Optionally, the input connector 305 may be connected to the adapter board 302 by the cable or copper bar. The adapter board 302 is connected to the power module assembly 303. The input connector 305 is connected to the external power supply source and supplies power to the power module assembly 303 through the adapter board 302.

Optionally, the input connector 305 may be connected to the backplane 304 by a cable or copper bar. The adapter board 302 is inserted into the backplane 304 and connected to the power module assembly 303. The input connector 305 is connected to the external power supply source and supplies power to the power module assembly 303 through the backplane 304 and the adapter board 302.

It should be noted that in some embodiments, the power module assembly 303 and the input connector 305 are usually integrated. One power supply equipped with one or two input connectors in a shell, where the input connectors provide external interfaces, forms a power module. As shown in FIG. 6, the power modules are configured in 2+2 configuration (that is, n is 2). 4 power modules are configured, among which 2 power modules serve as redundant power backups. In FIG. 6, the 4 power modules are independent. Each power module includes one power supply and one input connector. That is, each power module shown in FIG. 6 is a single-input power module. In this case, the data center provides two power supply inputs, each of which connects to 2 power modules. Each power module is connected to one power supply input. If one power supply input fails, the other power supply input supplies power needed for normal operation of the power module. It can be seen that in FIG. 6, the power supply and the input connector of each of the 4 power modules are fixedly connected in the shell, that is, the power supply and the input connector are non-detachably connected.

In the embodiment of the present application, the power module assembly 303 and the input connector 305 are independent of each other and may be connected by a cable, copper bar, or the like.

In some embodiments, as shown in FIG. 5, the adapter board 302 is connected to the power module assembly 303 by means of plugging and a cable. Furthermore, since the power module assembly 303 and the input connector 305 are independent of each other, the input connector 305 and the adapter board 302 may be connected by the cable or copper bar and the input connector 305 may be connected to the power module assembly 303 based on the adapter board 302. Optionally, the input connector 305 may be connected to the backplane 304 by the cable or copper bar and the input connector 305 may be connected to the power module assembly 303 based on the adapter board 302 and the backplane 304.

In some embodiments, the backplane 304 is connected to the power module assembly 303 by insertion, a cable, or the like. Further, since the power module assembly 303 and the input connector 305 are independent of each other, the input connector 305 may be connected to the backplane 304 by a cable, copper bar, or the like and the input connector 305 may be connected to the power module assembly 303 based on the backplane 304.

In the embodiment of the present application, the power module assembly 303 and the input connector 305 are deployed independently, which makes flexible connection between the power module assembly 303 and the input connector 305 possible. A connection mode between the power module assembly 303 and the input connector 305 allows the power module assembly 303 configured with n+1 power modules to be flexibly compatible with power supply inputs from 2(n+1) and 2n branches. In this way, if the configuration of the existing data center does not support the power supply inputs from the 2(n+1) branches, for example, if the RPPs cannot provide sufficient interfaces for connecting to the power supply sources and the computer room needs to be reconstructed, the power supply inputs from the 2n branches may be adopted to save interfaces of the power supply sources and the RPPs and avoid computer room reconstruction.

The following describes a structure of the power module assembly 303 in the server 201 by taking the server 201 for example.

In a schematic structural diagram of the power module assembly 303 in FIG. 7, the power module assembly 303 includes (n+1) power modules. Each power module includes one power supply and one two-way changeover switch that is connected to the power supply. Each power supply includes two ports. One port is connected to a corresponding two-way changeover switch and the other port is connected to a load, to supply power to the load. The load may be any device or electronic component that needs to be powered, for example, a computing device such as a server, a switching device such as a switch or router, or an electronic component such as a processor or a chip.

Two inputs are connected to the two-way changeover switch, which may be input A and input B. Input A and input B are respectively connected to the two-way changeover switch by the input connector 305. The two-way changeover switch may automatically switch to the other input when either of the two inputs fails, to avoid the load being affected by power failure.

In some embodiments, the two-way changeover switch may be supported to set either of the two inputs such as input A as a default input to power the load. When the default input fails, the two-way changeover switch immediately switches the load to input B. Optionally, after the default input such as input A functions normally, the two-way changeover switch may switch the load back to the default input.

Specifically, the two-way changeover switch may integrate a break before make switch or rectify AC to DC and combine DC. In this case, the power supply can operate normally when there is power from either input A or input B.

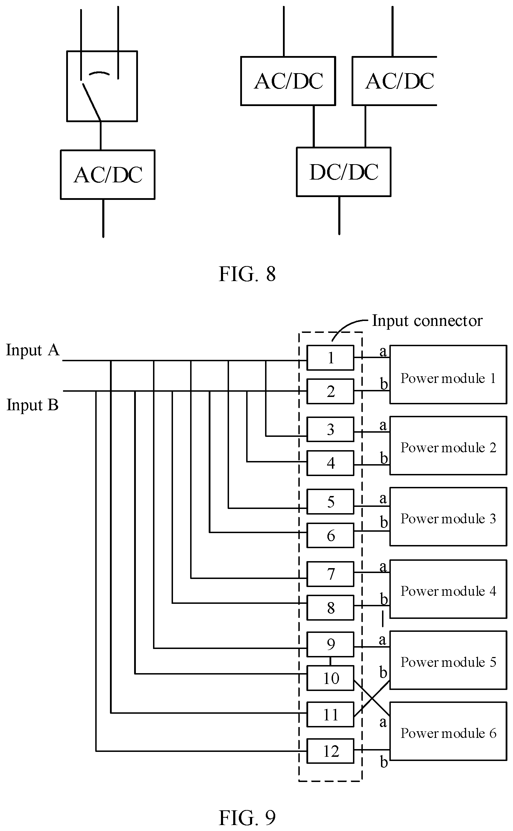

As shown in FIG. 8, left figure in FIG. 8 shows a static transfer switch (STS), which may implement uninterrupted switching between different power supply sources. An AC/DC convertor is a power converter that inputs AC and outputs DC. The AC/DC convertor uses a secondary-side rectifier diode to rectify high-frequency AC voltage, uses a capacitor to smooth it, and then converts it to a set DC output voltage. In some embodiments, in a normal operating state, a default power supply source is within a normal voltage range, and powers the load. When the default power supply source fails, the load is automatically switched to a backup power supply source. After the default power supply source operates normally, the load is automatically switched to the default power supply source.

In right figure of FIG. 8, a DC/DC convertor is a power converter that inputs DC and outputs DC. The DC/DC convertor may convert electric energy from one voltage level to another. The two-way changeover switch receives AC from two power supply sources. Each input AC is rectified into DC by an AC/DC converter. The DC/DC converter combines DC from two converters and outputs DC with a preset voltage level. When one of the two power supply sources fails, the output of the two-way changeover switch is not affected.

In some embodiments, the power module assembly 303 may be integrated. Specifically, the two-way changeover switch may be integrated into a power supply, which may reduce assembly operations and improve assembly efficiency, reduce the size of the power module assembly 303 and save space, thereby achieve protection of the two-way changeover switch.

In some embodiments, the two-way changeover switch is not integrated in the power module assembly 303 but the server 201.

Optionally, the power module assembly 303 may be set detachable. Specifically, the power supply may be connected to a switch slot and the two-way changeover switch may be plug-connected to the power supply through the switch slot. Optionally, as shown in FIG. 5, the adapter board 302 is plug-connected to the power module assembly 303. The adapter board 302 is conducted in a direction perpendicular to the power module assembly 303. After pins of two-way changeover switches corresponding to a plurality of power modules in the power module assembly 303 are inserted along a line in the direction perpendicular to the power module assembly 303, the power modules and two-way changeover switches may be connected. Further, corresponding ports may be inserted in corresponding positions on the adapter board 302, which may be positions on the straight lines where the power supplies and the two-way changeover switches are located, so that the ports are connected to the two-way changeover switches, and the two inputs may be connected to the two-way changeover switches through the ports. In this way, in some application scenarios such as a single-way input scenario, the two-way changeover switch may be removed and the power supply directly supplies power to the load, thereby improving compatibility of the power module assembly 303.

The following describes how the power module assembly 303 and the input connector 305 are connected in the embodiment of the present application. The embodiment of the present application provides a design that is compatible with power supply inputs from 2(n+1) branches and 2n branches based on how the power module assembly 303 and the input connector 305 are connected. Optionally, the power module assembly 303 may be configured with n+1 power modules.

FIG. 9 shows a power module assembly with a 5+1 (n=5) power configuration by taking the server 202 shown in FIG. 2 for example. In FIG. 9, there are 6 power modules and 12 input connectors. All the 6 power modules are dual-input power modules. Among the 12 input connectors, 10 input connectors are fixed input connectors (input connectors 1 to 10) and 2 input connectors are expansion input connectors (input connectors 11 and 12). Each power module includes port a and port b and receives two power supply inputs (input A and input B) through two input connectors which are connected to the power module. Input connectors 1, 3, 5, 7, 9, and 10 are respectively connected to ports a of power modules 1, 2, 3, 4, 5, and 6. Input connectors 2, 4, 6, 8, 11, and 12 are respectively connected to ports b of power modules 1, 2, 3, 4, 5, and 6. In the embodiment of the present application, the ports a may be referred to as first input ports and the ports b may be referred to as second input ports.

In some embodiments, in a case that the configuration of the data center supports, for example, interfaces for connecting the power supply source and the RPPs and power lines are sufficient, the input connectors 1, 3, 5, 7, 9, and 11 are connected to input A and the input connectors 2, 4, 6, 8, 10, and 12 are connected to input B. As shown in FIG. 9, in this case, if the power of the server is 15 kW and the power of each power module is 3 kW, and the data center provides 6 branches of input A and 6 branches of input B, 12 branches in total, for each power module, where input A and input B are independent of each other.

In a normal power supply status, the 6 power modules may provide a power supply capability of 3 kW x 6 = 18 kW. In an abnormal power supply status, for example, if input A fails, the 6 power modules connected to input B may provide 3 kW x 6 = 18 kW of power, or if one power module connected to input B fails, the other 5 power modules may provide 3 kW x 5 = 15 kW of power. If input A or input B fails or one of the 6 power modules fails, power supply reliability can be guaranteed and services are not affected.

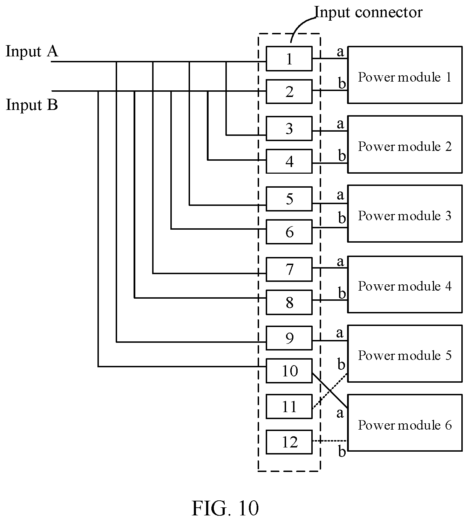

In some embodiments, in a case that the configuration of the data center does not support, for example, the interfaces for connecting the power supply sources and the RPPs and the power lines are insufficient, the input connector 11 and the input connector 12 as expansion input connectors are not connected to the power modules, and do not affect power supply. As shown in FIG. 10, the input connectors 1, 3, 5, 7, and 9 are connected to input A and the input connectors 2, 4, 6, 8, and 10 are connected to input B. In this case, if the power of the server is 15 kW and the power of each power module is 3 kW, the data center provides 5 branches of input A and 5 branches of input B, 10 branches in total, for 10 power modules respectively. Input A and input B are independent of each other.

It can be seen that the input connector 9 is connected to port a of the power module 5 and the input connector 10 is connected to port a of the power module 6. The power module 5 and the power module 6 respectively receive only one power supply. In FIG. 10, the power module 5 only receives power from input A and the power module 6 only receives power from input B. In the normal power supply status, the 6 power modules may have a power supply capability of 3 kw x 6 = 18 kw. In addition, the 6 power modules are connected to only 10 branches, saving two RPP interfaces.

In an abnormal power supply status, for example, if input A fails, the 5 power modules (power modules 1, 2, 3, 4, and 5) connected to input B may provide 3 kW x 5 = 15 kW of power, or if input B fails, the 5 power modules (power modules 1, 2, 3, 4, and 5) connected to input A may provide 3 kW x 5 = 15 kW of power, or if one power module fails, the other 5 power module may provide 3 kW x 5 = 15 kW of power. If input A or input B fails or one of the 6 power modules fails, power supply reliability can be guaranteed and services are not affected.

Generally, the power modules and the input connectors are connected in a one-to-one order in sequence. The power supply sources/RPPs and the input connectors are connected in a left-to-right order. As shown in FIG. 9 and FIG. 10, the power module 5 and the power module 6 are not connected to the input connectors in sequence, that is, the power module 5 is not connected to the input connector 9 and the input connector 10 and the power module 6 is not connected to the input connector 11 and the input connector 12. In the embodiment of the present application, the power module 5 is cross-connected to the input connector 9 and the input connector 11 and the power module 6 is cross-connected to the input connector 10 and the input connector 12 so that the input connector 11 and the input connector 12 may be used as expansion input connectors. If the data center configuration does not support the general connection method, the power supply sources/RPPs are connected to first 10 input connectors in a left-to-right order. The power modules 1 to 4 respectively receive power from two inputs and the power modules 5 and 6 respectively receive power from one power supply. In this case, normal and reliable power supply may also be achieved.

Generally, when the dual-input power module receives power from only one power supply, an alarm will be generated, indicating that power supply is abnormal. Therefore, two power modules (such as the power modules 5 and 6) in the power module assembly provided in the embodiment of the present application are compatible with dual-input power supply and single-input power supply. When the two power modules receive power from only one power supply, no alarm will be generated and a load will be powered normally.

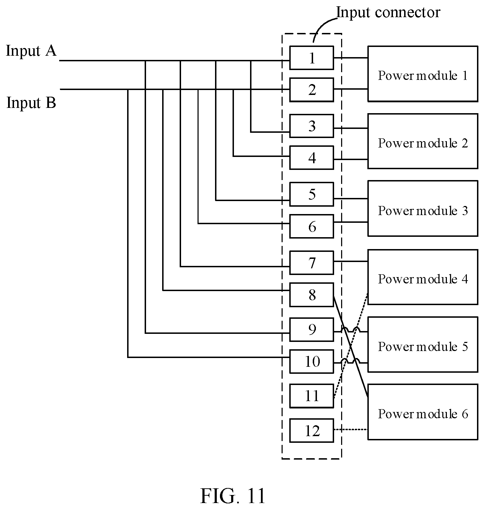

In some embodiments, connection modes between the power modules and the input connectors are not limited to those shown in FIG. 9 and FIG. 10. By way of example, the power modules 1, 2, 3, and 5 respectively receive power from two inputs and the power modules 4 and 6 respectively receive power from one power supply. In this case, the connection mode may be as shown in FIG. 11, the power module 4 is connected to the input connector 7 and the input connector 11, and the power module 6 is connected to the input connector 8 and the input connector 12, so that the input connector 11 and the input connector 12 may be used as expansion input connectors.

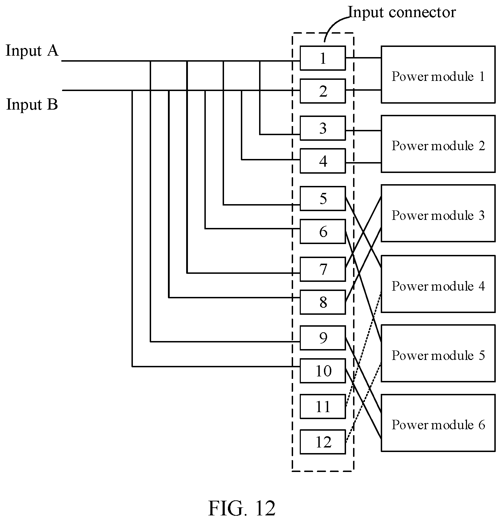

By way of another example, the power modules 1, 2, 3, and 6 respectively receive power from two inputs and the power modules 4 and 5 respectively receive power from one power supply. In this case, the connection mode may be shown in FIG. 12, the power module 3 is connected to the input connector 7 and the input connector 8, and the power module 4 is connected to the input connector 5 and the input connector 11, the power module 5 is connected to the input connector 6 and the input connector 12, and the power module 6 is connected to the input connector 9 and the input connector 10, so that the input connector 11 and the input connector 12 may be used as expansion input connectors.

It is understandable that the power modules and the input connectors may be connected in various other modes, which are not limited in the embodiment of the present application.

Generally, the input connectors are connected sequentially according to industry-wide interface conventions. Therefore, last two input connectors are used as expansion input connectors. For users, one dual-input power supply corresponds to two input connectors. Taking the server 201 shown in FIG. 9 for example, the users may observe 12 input connectors, each two of which are one group. The user may use a last group of input connectors (that is, the last two input connectors) as the expansion input connectors or use any group of input connectors as the expansion input connectors.

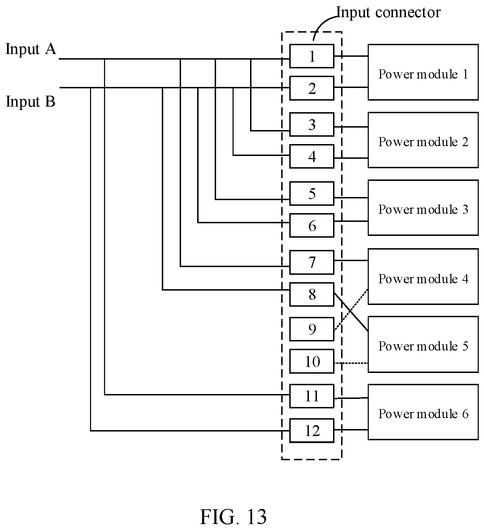

In some embodiments, the expansion input connectors may be the input connectors 9 and 10, and the fixed input connectors may be the input connectors 1 to 8, the input connector 11, and the input connector 12. In this case, the power modules and the input connectors may be connected as shown in FIG. 13. In FIG. 13, the input connectors 9 and 10 as the expansion input connectors are not connected. The input connectors 1, 3, 5, 7, and 11 are connected to input A and the input connectors 2, 4, 6, 8, and 12 are connected to input B. In this case, the power modules 4 and 5 respectively receive power from one power supply. The power module 4 receives power from input A through the input connector 7, and the power module 5 receives power from input B through the input connector 8. When the power supply sources are normal, 6 power modules may supply power. In addition, the 6 power modules are connected to only 10 branches, saving two RPP interfaces.

Optionally, the expansion input connectors may be the input connectors 1 and 2, and the fixed input connectors may be the input connectors 3 to 12. The specific internal connection lines may be inferred from the foregoing description, and will not be repeated here.

Optionally, the expansion input connectors may be the input connectors 3 and 4, and the fixed input connectors may be the input connector 1, input connector 2, and input connectors 5 to 12. The specific internal connection lines may be inferred from the foregoing description and is not repeated here.

Optionally, the expansion input connectors may be the input connector 5 and the input connector 6, and the fixed input connectors may be the input connectors 1 to 4 and the input connectors 7 to 12. The specific internal connection lines may be inferred from the foregoing description and is not repeated here.

Optionally, the expansion input connectors may be the input connector 7 and the input connector 8, and the fixed input connectors may be the input connectors 1 to 6 and the input connectors 9 to 12. The specific internal connection lines may be inferred from the foregoing description, and is not repeated here.

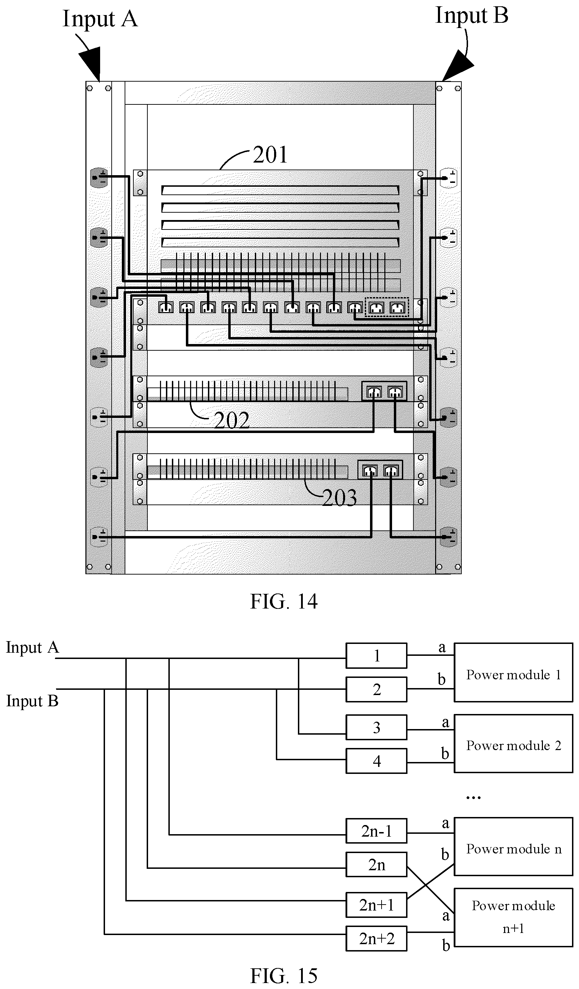

By taking how the n+1 power modules (n=5) and input connectors in the server 201 are connected as described in FIG. 9 (FIG. 10, FIG. 11, or FIG. 12) for example, the following describes how external RPPs are connected to the server 201. As shown in FIG. 14, the server 201 includes 10 fixed input connectors (first to 10th input connectors from left to right correspond to the input connectors 1 to 10 shown in FIG. 14), and 2 expansion input connectors (11th to 12th input connectors from left to right correspond to the input connectors 11 to 12 shown in FIG. 9).

It can be seen that in a case that the server 202 and the server 203 are normally connected to the power supply sources, the RPP 211 and the RPP 212 each have 5 power supply interfaces left, not enough for one-to-one connection to the 12 input connectors of the server 201. The embodiment of the present application designs a connection mode between the power modules and the input connectors in the server 201 (for example, as shown FIG. 9), through which only 10 input connectors of the server 201 need to be connected to the power supply sources, to achieve normal and reliable power supply to the server 201.

The embodiment of the present application provides a power module assembly. A power type of the power module assembly is a dual-input power module. A power configuration mode of the power module assembly is n+1 configuration. Based on the design of the connection mode between the power module assembly 303 and the input connector 305, two power modules may receive power from one power supply and two inputs, and remaining n-1 power modules respectively receive power from two inputs. The (n+1) power modules need to be equipped with 2(n+1) input connectors. The 2(n+1) input connectors include 2 expansion input connectors and 2n fixed input connectors. When the 2n fixed input connectors and the 2 expansion input connectors receive power from the power supply sources, the (n+1) power modules may supply power to the server 201 in a normal and reliable manner. When the 2n fixed input connectors receive power from the power supply sources and the two expansion input connectors do not receive power from the power supply sources, the (n+1) power modules may still supply power to the server 201 in a normal and reliable manner, that is, the power module assembly may be compatible with power supply inputs from the 2(n+1) branches and the 2n branches.

In actual application, once connected to the input connectors, the power modules can be directly mounted on the rack. When supported by the data center configuration during use, each power module is connected to two expansion input connectors. When not supported by the data center configuration, each power module is not connected to the two expansion input connectors, and does not affect a power supply capability of the power module provided in the embodiment of the present disclosure. In addition, in a case that the two expansion input connectors are not connected, interfaces on the RPPs may be allocated to other electronic devices, which expands a scale of devices capable of being supported by the data center without changing a configuration and a structure of the data center.

In some embodiments, a plurality of input connectors may be labeled with sequential numerals, indicating that the user sequentially connects the input connectors to interfaces of the power supply sources. For example, each input connector on a cabinet of the server 201 is labeled with a sequential numeral, if the sequential numeral starts from 1, an input connector labeled with 1 is the input connector 1 in the embodiment of the present application, an input connector labeled with 2 is the input connector 2 in the embodiment of the present application, and so on. If the sequential numeral starts from 0, an input connector labeled with 0 is the input connector 1 in the embodiment of the present application, the input connector labeled with 1 is the input connector 2 in the embodiment of the present application, and so on. If the sequential numeral starts from a, the input connector labeled with a is the input connector 1 in the embodiment of the present application, the input connector labeled with b is the input connector 2 in the embodiment of the present application, and so on. In FIG. 14, first 10 input connectors of the server 201 are connected to interfaces of the power supply sources and last 2 input connectors of the server 201 as expansion input connectors are not connected to the interfaces of the power supply sources.

In some embodiments, the fixed input connectors and the expansion input connectors are easily distinguished from each other. For example, the fixed input connectors and the expansion input connectors may have different types of interfaces, be made from different materials, or have different identifiers. In terms of identifiers, the expansion input connectors may have special identifiers. For example, in FIG. 12, interfaces of last two input connectors in the server 201 are labeled with a dashed box, and identifiers of the fixed input connectors or the expansion input connectors are noted in related operation instructions, and so on.

In the embodiment of the present application, the fixed input connectors may also be referred to as non-expansion input connectors.

The above describes a connection and a power supply situation of n+1 power configuration (n=5). For any value of n, the connection mode in the embodiment of the present application may be adopted.

As shown in FIG. 15, there are (n+1) power modules and 2(n+1) input connectors. The input connectors are used to connect the power modules and the power supply sources. The (n+1) power modules are dual-input power modules, and each power module includes a first input port and a second input port that are respectively connected to one input connector, where n is a positive integer.

Based on positions of the 2(n+1) input connectors, when 2n input connectors among the 2(n+1) input connectors are connected to the power supply sources and a (2a+1)th input connector and a (2a+2)th input connector among the 2(n+1) input connectors are not connected to the power supply sources, the (n+1) power modules in the power module assembly achieve power supply, where a is a non-negative integer, and is less than or equal to n.

The input connectors are used to connect the power supply sources and the power modules and transmit power provided by the power supply sources to the power modules. The 2(n+1) input connectors include 2n fixed input connectors (input connectors 1 to 2n) and 2 expansion input connectors (the (2a+1)th input connector and the (2a+2)th input connector). Each power module includes a first input port and a second input port, and receives power from two power supply inputs (input A and input B) by being connected to the two input connectors.

It should be noted that the (2a+1)th input connector and the (2a+2)th input connector may be determined based on positions of the input connectors. For example, when the 2(n+1) input connectors are placed in a row/column, the (2a+1)th input connector and the (2a+2)th input connector may be identified in a left to right/top to bottom order. When the 2(n+1) input connectors are placed in two rows, the (2a+1)th input connector and the (2a+2)th input connector may be identified in an order from left to right and then top to bottom, that is, the (2a+1)th input connector and the (2a+2)th input connector may be identified in an order of first and second in a first row. When the 2(n+1) input connectors are placed in two areas, the (2a+1)th input connector and the (2a+2)th input connector may be identified in an order of first and second in a first area, which are not listed one by one here.

The (2a+1)th input connector and the (2a+2)th input connector may also be determined based on their preset sequential numerals, which is not limited in the present application.

The power module provided in the embodiment of the present application is in the form of n+1 power configuration, and may be flexibly compatible with power supply inputs from the 2(n+1) branches and the 2n branches. In this case, if the configuration of the existing data center supports the power supply inputs from the 2(n+1) branches, for example, if the number of interfaces for power supply sources and RPP is sufficient, the power supply inputs from the 2(n+1) branches may be adopted. If the configuration of the existing data center does not support the power supply inputs from the 2(n+1) branches, for example, if the number of interfaces for power supply sources and RPP is not sufficient and the computer room needs to be reconstructed, the power supply inputs from the 2n branches may be adopted, and the (2a+1)th and (2a+2)th input connectors are not connected to the power supply inputs, saving interfaces of the RPPs and the power supply sources and avoiding computer room reconstruction without affecting normal power supply.

Since the (2a+1)th input connector and the (2a+2)th input connector may be or may not be connected to the power supply sources, the (2a+1)th input connector and the (2a+2)th input connector may be referred to as expansion input connectors. The remaining 2n input connectors among the 2(n+1) input connectors need to be connected to the power supply sources, and may be referred to as fixed input connectors or non-expansion input connectors.

In a possible implementation, the (n+1) power modules include a first power module and a second power module. A first input port of the first power module is connected to a (2b+1)th input connector, a second input port of the first power module is connected to the (2a+1)th input connector, a first input port of the second power module is connected to a (2b+2)th input connector, and a second input port of the second power module is connected to the (2a+2)th input connector, where b is a non-negative integer, and is less than or equal to n, and b is not equal to a.

In a possible implementation, when 2n input connectors among the 2(n+1) input connectors are connected to the power supply input of the power supply sources, and the (2a+1)th input connector and the (2a+2)th input connector among the 2(n+1) input connectors are not connected to the power supply input of the power supply sources, the first power module and the second power module receive one power supply input of the power supply sources and achieve power supply; and among the (n+1) power modules, except for the first power module and the second power module, remaining (n-1) power modules receive two power supply inputs of the power supply sources and achieve power supply.

The (2a+1)th input connector and the (2a+2)th input connector are not connected to the power supply sources. However, since the (n+1) power modules in the power module assembly are dual-input power modules and the (2a+1)th input connector and the (2a+2)th input connector are respectively connected to two power modules, which are the first power module and the second power module, the first power module and the second power module respectively receive power from one power supply. Generally, for the dual-input power module, when the dual-input power module only receives the power from one power supply input, an alarm will be generated, indicating that the power supply is abnormal. Therefore, the first power module and the second power module in the power module assembly provided in the embodiment of the present application may be compatible with power supply from one input and power supply from two inputs. When either of the two power modules receives power from only one power supply, no alarm will be generated and power will be supplied to the load normally. Optionally, the power module assembly includes 2(n+1) input connectors, each two of which are one group. The (2a+1)th input connector and the (2a+2)th input connector may be a last group of input connectors (that is, last two input connectors) or any group of input connectors.

In some embodiments, among the 2(n+1) input connectors, excluding the (2a+1)th input connector and the (2a+2)th input connector, all odd-numbered input connectors are connected to one power supply input of the power supply sources, and all even-numbered input connectors are connected to the other power supply input of the power supply sources. The odd-numbered input connectors are 1st, 3rd, ..., (2n-1)th, and (2n+1)th input connectors and the even-numbered input connectors are 2nd, 4th, ..., (2n)th, and (2n+2)th input connectors. When the one power supply input which is connected to all the odd-numbered input connectors fails, the other power supply input supplies power to n power modules which are connected to all the even-numbered input connectors, and the n power modules include remaining power modules among the (n+1) power modules that except the first power module. When the one power supply input which is connected to all the even-numbered input connectors fails, the other power supply input supplies power to the n power modules which are connected to all the odd-numbered input connectors, the n power modules include remaining power modules among the (n+1) power modules that except the second power module. Alternatively, when one of the (n+1) power modules fails, remaining n power modules supply power.

In some embodiments, a is equal to n. Based on positions of the (n+1) power modules and the 2(n+1) input connectors, a first input port of an nth power module is connected to the (2n-1)th input connector, a second input port of the nth power module is connected to the (2n+1)th input connector, a first input port of an (n+1)th power module is connected to the (2n)th connector, and a second input port of the (n+1)th power module is connected to the (2n+2)th input connector.

According to industry-wide interface conventions, input connectors are connected sequentially. Therefore, a last group of input connectors, that are, last two input connectors, serve as expansion input connectors, and the last two power modules respectively receive power from one power supply. A most possible connection mode is provided, which fully adapts to users' interface habits and is universally applicable to practical applications. The following describes the connection mode by taking a being equal to n for example.

In a scenario where the data center configuration supports the connection mode, as shown in FIG. 15, 2(n+1) input connectors are connected to power supply inputs and (n+1) power modules in the power module assembly supply power to the load. When the one power supply input which is connected to the odd-numbered input connectors fails, the other power supply input which is connected to the even-numbered input connectors are connected supplies power to the (n+1) power modules to which the even-numbered input connectors are connected. When one of the (n+1) power modules is fails, remaining n power modules supply power.

In some embodiments, based on spatial positions of the (n+1) power modules and the 2(n+1) input connectors, the odd-numbered input connectors are connected to one power supply input and the even-numbered input connectors are connected to the other power supply input. In a scenario where the data center configuration does not support connection of the (2n+1)th input connector and the (2n+2)th input connector to the power supply inputs, the (2n+1)th input connector and the (2n+2)th input connector are used as expansion input connectors and power supply is not affected.

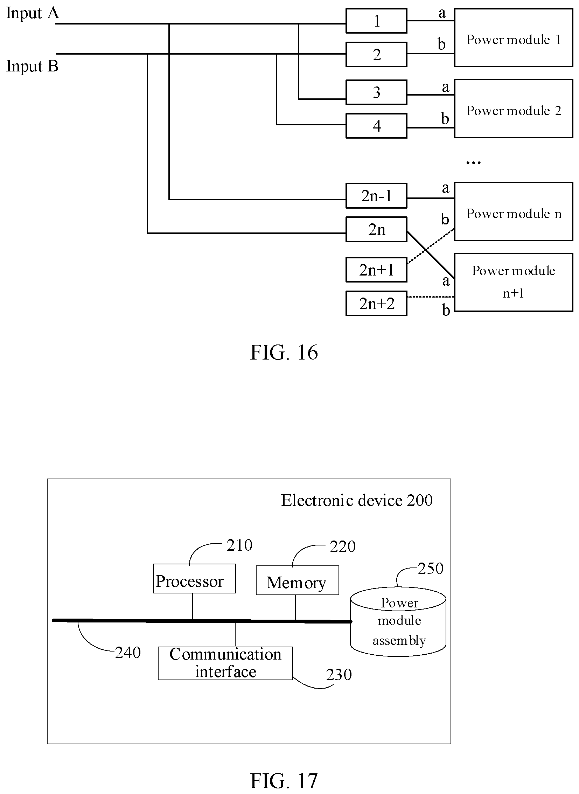

As shown in FIG. 16, when 2n consecutive input connectors among the 2(n+1) input connectors are connected to power supply inputs and the (2n+1)th input connector and the (2n+2)th input connector are not connected to power supply inputs, the (n+1) power modules in the power module assembly achieve power supply. When one power supply input which is connected to the odd-numbered input connectors fails, the other power supply input which is connected to the even-numbered input connectors supplies power to the n power modules to which the even-numbered input connectors are connected. When one of the (n+1) power modules fails, remaining n power modules supply power.

It can be seen that an input connector (2n-1) is connected to port a of the power module n, the input connector (2n) is connected to port b of a power module n, and the power module n and a power module (n+1) respectively receive power from only one pow input. In FIG. 16, the power module n receives power from input A and the power module (n+1) receives power from input B. When power supply is normal, the (n+1) power modules may supply power. When power supply is abnormal, for example, if input A fails, n power modules (power modules 1, 2, ... , n-1, and n+1) from input B may supply power, or if input B fails, n power modules (power module 1, 2, 3, ... , n-1, and n) from input A may supply power, or if one power module fails, the remaining n power modules may supply power. If input A or input B fails or one of the power modules fails, power supply reliability can be guaranteed and services are not affected.

In some embodiments, input connectors 1, 3, ..., 2n-3, and 2n-1 are respectively connected to ports a of power modules 1, 2, ..., n, and n+1, and input connectors 2, 4, 6, ..., 2n-2, and 2n+2 are respectively connected to ports b of power modules 1, 2, ..., n, and n+1. The input connector 2n is connected to port a of the power module n+1 and the input connector 2n+1 is connected to port b of the power module n.

In some embodiments, a first input port of an ath power module is connected to a (2b-1)th input connector, a second input port of the ath power module is connected to the (2n+1)th input connector, a first input port of a cth power module is connected to a (2b)th input connector, and a second input port of the cth power module is connected to the (2n+2)th input connector, where a, b, and c represent positive integers, and are less than or equal to (n+1). In this case, the input connector (2n+1) and the input connector (2n+2) as expansion input connectors are not connected, the power module a and the power module c respectively receive power from only one power supply, and the (n+1) power modules in the power module assembly supply power.

The power modules provided in the embodiment of the present application is applicable to any electronic device that requires power modules. The electronic device may be a computer device, a storage device, a wireless device, a network device, or the like. The embodiment of the present application does not limit a specific form of the electronic device. For example, the electronic device may be referred to as a terminal, user equipment (UE), terminal device, access terminal, subscriber unit, subscriber station, mobile station, remote station, remote terminal, mobile device, user terminal, wireless communication device, user agent, subscriber installation, or the like. A terminal may be a mobile phone, augmented reality (AR) device, virtual reality (VR) device, tablet, laptop, ultra-mobile personal computer (UMPC), netbook, personal digital assistant (PDA), or the like. A network device may a server or the like. The server may be a physical server, logical server, or two or more physical or logical servers that share different responsibilities and cooperate with each other to implement various server functions.

The electronic device includes a processor and a memory that are connected to each other. The memory stores a computer execution instruction and the processor executes the computer execution instruction to implement a data processing method in the foregoing embodiment.

In terms of hardware implementation, the electronic device may be connected in the way shown in FIG. 17. FIG. 17 is a hardware schematic structural diagram of an electronic device 200 according to the embodiment of the present application. The electronic device 200 may be used to implement functions of the above electronic device.

The electronic device 200 shown in FIG. 17 may include a processor 210, a memory 220, a power module assembly 250, a communication interface 230, and a bus 240. The processor 210, the memory 220, the power module assembly 250, and the communication interface 230 may be connected by the bus 240.

The processor 210 may include one or more processing units. For example, the processor 210 may include a central processing unit (CPU), an application processor (AP), a modem processor, a graphics processing unit (GPU), an image signal processor (ISP), a controller, a memory, a video codec, a digital signal processor (DSP), a baseband processor, a baseboard management controller (BMC), a system management mode (SMM), and/or a neural-network processing unit (NPU), and the like. Different processing units may be independent devices or may be integrated into one or more processors. The controller may be a neural center and a command center of the electronic device 200. The controller may generate operation control signals based on instruction operation codes and timing signals to complete control of a fetching instruction and an execution instruction.

The memory 220 may be but is not limited to be a read-only memory (ROM), a static storage device of another type that may store static information and instructions, a random access memory (RAM), a dynamic storage device of another type that may store information and instructions, an electrically erasable programmable read-only memory, a magnetic disk storage medium or a magnetic storage device of another type, or any other medium that may carry or store desired program codes in the form of instruction or data structure and may be accessed by a computer.

In some embodiments, the memory 220 may be independent of the processor 210. The memory 220 may be connected to the processor 210 by the bus 240 to store data, instructions, or program codes. The processor 210 may realize the video processing method provided in the embodiment of the present application by invoking and executing instructions or program codes stored in the memory 220. In some embodiments, the memory 220 and the processor 210 may be integrated.

The communication interface 230 is used for connecting the electronic device 200 to other devices via a communication network, for example, an Ethernet network, a radio access network (RAN), a wireless local area networks (WLAN), or the like. The communication interface 230 may include a receiving unit for receiving data and a transmitting unit for transmitting data.

The bus 240 may be an industry standard architecture (ISA) bus, a peripheral component interconnect (PCI) bus, an extended industry standard architecture (EISA) bus, or the like. The bus may be divided into an address bus, a data bus, a control bus, and the like.

The power module assembly 250 is used to receive power from two power supply inputs of power supply sources and supply power to a load of the electronic device 200 (including the processor 210, the memory 220, the communication interface 230, and the like). The detailed description of the power module assembly 250 may include relevant description of the power module assembly 303 in the foregoing embodiment, which is not repeated here.

In some embodiments, the power module assembly 250 is connected to 2(n+1) input lines one by one based on the 2(n+1) input connectors to receive power supply input from external power supply resources. The processor 210 is used to detect, when the 2(n+1) input lines are present and power supply normally, and the first input port and the second input port of the (n+1) power modules have the power supply input respectively, determining the power module assembly is in a normal power supply status. The normal power supply status indicates that the power modules in the power module assembly 250 may receive power and supply power to the load in a stable manner. In such implementation mode, when each of the (n+1) power modules in the power module assembly 250 receives power from two inputs, it is considered that the power module assembly 250 is in the normal power supply status.

In some embodiments, the power module assembly 250 is connected to 2n power supply input lines one by one based on the 2n input connectors among the 2(n+1) input connectors, to receive a power supply input from the external power supply sources. The processor 210 is used to detect, when the 2n input lines are present and power supply normally, and the first input port and the second input port of (n-1) power modules among the (n+1) power modules have a power supply input respectively, and one input port of two power modules among the (n+1) power modules have the power supply input, determining the power module assembly is in a normal power supply status. In general, only when the dual-input power module receives power from two inputs, it is considered to be in the normal power supply status. When the dual-input power module only receives power from one power supply, an alarm will be generated, and indication information of abnormal power supply will be output. The indication information, for example, may indicate that the other power supply input is abnormal. In such implementation mode, two power modules in the power module assembly 250 may be compatible with one power supply input and two power supply inputs, that is, when the two power modules respectively receive power from only one power supply, no alarm will be generated and power will be supplied normally. In this case, the power module assembly 250 is considered to be in the normal power supply status.

Optionally, the processor 210 is further used to detect, when the power module assembly 250 connected to the 2n input connectors is present and supplies power normally, and a first input port and a second input port of the (n-1) power modules among the (n+1) power modules have a power supply input respectively and one input port of the 2 power modules among the (n+1) power modules have the power supply input, and one of the 2 power modules receives power from one power supply input of the power supply sources, and the other power module receives power from the other power supply input of the power supply sources, determining the power module assembly 250 is in a normal power supply status.

Optionally, the electronic device 200 records identifiers of two power modules that may receive power from one input or two inputs in the power module assembly 250. The processor 210, is used to detect, when the two power modules respectively receive power from only one power supply input and the first input port and the second input port of other (n-1) power modules than the two power modules have a power supply input respectively, determining the power module assembly 250 is in the normal power supply status.

Optionally, the electronic device 200 records identifiers of two power modules in the power module assembly 250, which may receive power from one input or two inputs. The processor 210, is used to detect, when the two power modules only receive power from one power supply based on the identifiers, and one of the two power modules receives power from one power supply and the other power module receives power from the other input of the power supply sources, and first input port and second input ports of other (n-1) power modules than the two power modules are provided with power supply inputs, determine that the power module assembly 205 is in the normal power supply status.

Optionally, the two power modules that may respectively receive power from one input or two inputs are power modules that are connected to the expansion input connectors.

It should be noted that the structure shown in FIG. 17 does not constitute a limitation of the electronic device 200. The electronic device 200 may include more or fewer components than those shown in the figure, or some components that may be combined, or some components that may be split, or different component arrangements.

The processes or functions in the foregoing embodiments may be implemented in whole or in part by software, hardware, firmware, or any combination thereof. If the processes or functions are implemented in software, they are implemented in whole or in part in the form of a computer program product. The computer program product includes one or more computer instructions. When the computer program instructions are loaded and executed on a computer, the processes or functions of the embodiment of the present application are generated in whole or in part. The computer may be a general-purpose computer, a special-purpose computer, a computer network, or a programmable device. Computer instructions may be stored in a computer-readable storage medium or transmitted from one computer-readable storage medium to another. For example, the computer instructions may be transmitted from a website, computer, server, or data center to another website, computer, server, or data center through a line such as a coaxial line, an optical fiber, or a digital subscriber line (DSL), or through wireless technologies such as infrared technology, radio technology, microwave technology, and the like. The computer-readable storage medium may be any available medium that may be accessed by computers or any data storage device that integrates one or more media such as a server or a data center. An available medium may be a magnetic medium (such as a floppy disk, a drive, or a magnetic tape), an optical medium (such as a DVD), a semiconductor medium (such as a solid state disk or SSD), or the like.

Although the present application has been described in combination with various embodiments, other variations in the disclosed embodiments will be understood and realized by those skilled in the art upon viewing the drawings, disclosure, and claims during the practice of the claimed application. In the claims, the term "comprising" does not exclude other elements or steps, and "one" does not exclude a plurality. A single processor or a unit may implement several functions enumerated in the claims. The fact that certain measures are noted in the dependent claims that are different from each other does not mean that these measures cannot be combined to produce good results.

Although the present application has been described in connection with specific features and embodiments thereof, it will be apparent that various modifications and combinations thereof may be made without departing from the spirit and scope of the present application. Accordingly, the specification and drawings are merely illustrative descriptions of the present application as defined by the appended claims and are deemed to cover any and all modifications, variations, combinations or equivalents within the scope of the present application. It will be apparent that those skilled in the art may make various modifications and variations of the present application without departing from the spirit and scope of the present application. Thus, the application is intended to include such modifications and variations to the extent that they fall within the scope of the claims and equivalents thereof.

## Claims

1. A power module assembly, comprising:
(n+1) power modules and 2(n+1) input connectors: the input connectors used for connecting power supply sources and the power modules, each of the power modules comprises a first input port and a second input port which are respectively connected to an input connector; wherein n is a positive integer;
based on positions of the 2(n+1) input connectors, when 2n input connectors among the 2(n+1) input connectors are connected to a power supply input of the power supply sources, and a (2a+1)th input connector and a (2a+2)th input connector among the 2(n+1) input connectors are not connected to the power supply input of the power supply sources, the (n+1) power modules among the power module assembly achieve power supply, wherein a is a non-negative integer, and is less than or equal to n.

2. The power module assembly according to claim 1, wherein each of the (n+1) power modules comprises a first power module and a second power module, wherein:
a first input port of the first power module is connected to a (2b+1)th input connector;
a second input port of the first power module is connected to the (2a+1)th input connector;
a first input port of the second power module is connected to a (2b+2)th input connector; and
a second input port of the second power module is connected to the (2a+2)th input connector, wherein b is a non-negative integer, and is less than or equal to n, and b is not equal to a.

3. The power module assembly according to claim 2, wherein when 2n input connectors among the 2(n+1) input connectors are connected to a power supply input of the power supply sources, and the (2a+1)th input connector and the (2a+2)th input connector among the 2(n+1) input connectors are not connected to the power supply input of the power supply sources, the first power module and the second power module receive power from one power supply input of the power supply sources respectively and achieve power supply; among the (n+1) power modules, except for the first power module and the second power module, remaining (n-1) power modules receive two power supply inputs of the power supply sources and achieve power supply.

4. The power module assembly according to claim 2 or 3, wherein among the 2(n+1) input connectors, excluding the (2a+1)th input connector and the (2a+2)th input connector, all odd-numbered input connectors are connected to one power supply input of the power supply sources, and all even-numbered input connectors are connected to the other power supply input of the power supply sources, wherein:
when the one power supply input which is connected to all the odd-numbered input connectors fails, the other power supply input supplies power to the n power modules which are connected to all the even-numbered input connectors, and the n power modules comprise remaining power modules among the (n+1) power modules that except the first power module; or
when the one power supply input which is connected to all the even-numbered input connectors fails, the other power supply input supplies power to the n power modules which are connected to all the odd-numbered input connectors, the n power modules comprise remaining power modules among the (n+1) power modules that except the second power module; or
when one of the (n+1) power modules fails, remaining n power modules supply power.

5. The power module assembly according to any one of claims 1 to 4, wherein the (2a+1)th input connector and the (2a+2)th input connector are expansion input connectors, among the 2(n+1) input connectors except the(2a+1)th input connector and the (2a+2)th input connector, remaining (2n-2) input connectors are non-expansion input connectors, and the expansion input connectors and the non-expansion input connectors have different identifiers.

6. The power module assembly according to claim 1, wherein the input connectors and the power modules are connected by a printed circuit board (PCB) and/or a backplane.

7. The power module assembly according to claim 1, wherein a is equal to n; based on positions of the (n+1) power modules and the 2(n+1) input connectors,
a first input port of an nth power module is connected to a (2n-1)th input connector;
a second input port of the nth power module is connected to the (2n+1)th input connector;
a first input port of an (n+1)th power module is connected to a 2nth input connector; and
a second input port of the (n+1)th power module is connected to a (2n+2)th input connector.

8. A power supply method, comprising:
a power module assembly receives dual power supply inputs from the power supply sources; the power module assembly supplies power to the load based on the dual power supply inputs; wherein the power module assembly comprises (n+1) power modules and 2(n+1) input connectors; input connectors used for connecting the power supply sources and the power modules; each power module comprises a first input port and a second input port which are respectively connected to an input connector; wherein n represents is a positive integer; based on positions of the 2(n+1) input connectors, when 2n input connectors among the 2(n+1) input connectors are connected to a power supply input of the power supply sources, and the (2a+1)th input connector and the (2a+2)th input connector among the 2(n+1) input connectors are not connected to the power supply input of the power supply input of the power supply sources, the (n+1) power modules among the power module assembly achieve power supply, wherein a represents a non-negative integer, and is less than or equal to n.

9. The method according to claim 8, wherein each of the (n+1) power modules comprises a first power module and a second power module, wherein:
a first input port of the first power module is connected to a (2b+1)th input connector;
a second input port of the first power module is connected to the (2a+1)th input connector;
a first input port of the second power module is connected to a (2b+2)th input connector; and
a second input port of the second power module is connected to the (2a+2)th input connector, wherein b is a non-negative integer, and is less than or equal to n, and b is not equal to a.

10. The method according to claim 9, wherein when the 2n input connectors among the 2(n+1) input connectors are connected to a power supply input of the power supply sources, the (2a+1)th input connector and the (2a+2)th input connector among the 2(n+1) input connectors are not connected to the power supply input of the power supply sources, and the first power module and the second power module receive power from one power supply input of the power supply sources respectively and achieve power supply; among the (n+1) power modules, except for the first power module and the second power module, remaining (n-1) power modules receive two power supply inputs of the power supply sources and achieve power supply.

11. The method according to claim 9 or 10, wherein among the 2(n+1) input connectors excluding the (2a+1)th input connector and the (2a+2)th input connector, all odd-numbered input connectors are connected to one power supply input of the power supply sources and all even-numbered input connectors are connected to the other power supply input of the power supply sources, wherein:
when the one power supply input which is connected to all the odd-numbered input connectors fails, the other power supply input supplies power to the n power modules which are connected to all the even-numbered input connectors, and the n power modules comprise remaining power modules among the (n+1) power modules that except the first power module; or
when the one power supply input which is connected to all the even-numbered input connectors fails, the other power supply input supplies power to the n power modules which are connected to all the odd-numbered input connectors, the n power modules comprise remaining power modules among the (n+1) power modules that except the second power module; or
when one of the (n+1) power modules fails, remaining n power modules supply power.

12. A computing device, comprising:
a power module assembly and a load; the power module assembly used for supplying power to the load based on a dual-input power supply;
wherein the power module assembly comprises (n+1) power modules and 2(n+1) input connectors; the input connectors used for connecting power supply sources and the power module, each power module comprises a first input port and a second input port which are respectively connected to an input connector; wherein n is a positive integer;
based on positions of the 2(n+1) input connectors, when 2n input connectors among the 2(n+1) input connectors are connected to a power supply input of the power supply sources, and a (2a+1)th input connector and a (2a+2)th input connector among the 2(n+1) input connectors are not connected to the power supply input of the power supply sources, (n+1) power modules in the power module assembly achieve power supply, wherein a is a non-negative integer, and is less than or equal to n.

13. The computing device according to claim 12, wherein each of the (n+1) power modules comprises a first power module and a second power module, wherein:
a first input port of the first power module is connected to a (2b+1)th input connector;
a second input port of the first power module is connected to the (2a+1)th input connector;
a first input port of the second power module is connected to a (2b+2)th input connector; and
a second input port of the second power module is connected to the (2a+2)th input connector, wherein b is a non-negative integer, and is less than or equal to n, and b is not equal to a.

14. The computing device according to claim 13, wherein when 2n input connectors among the 2(n+1) input connectors are connected to the power supply input of the power supply sources, the (2a+1)th input connector and the (2a+2)th input connector among the 2(n+1) input connectors are not connected to the power supply input of the power supply sources, the first power module and the second power module receive power from one power supply input of the power supply sources respectively and achieve power supply; among the (n+1) power modules, except for the first power module and the second power module, remaining (n-1) power modules receive two power supply inputs of the power supply sources and achieve power supply.

15. The computing device according to claim 13 or 14, wherein among the 2(n+1) input connectors excluding the (2a+1)th input connector and the (2a+2)th input connector, all odd-numbered input connectors are connected to one power supply input of the power supply sources and all even-numbered input connectors are connected to the other power supply input of the power supply sources, wherein:
when the one power supply input which is connected to all the odd-numbered input connectors fails, the other power supply input supplies power to the n power modules which are connected to all the even-numbered input connectors, and the n power modules comprise remaining power modules among the (n+1) power modules that except the first power module; or
when the one power supply input which is connected to all the even-numbered input connectors fails, the other power supply input supplies power to the n power modules which are connected to all the odd-numbered input connectors, the n power modules comprise remaining power modules among the (n+1) power modules that except the second power module; or
when one of the (n+1) power modules fails, remaining n power modules supply power.

16. The computing device according to claim 12, wherein the power module assembly is connected to 2(n+1) input lines one by one based on the 2(n+1) input connectors to receive the power supply input from the power supply sources, and the load comprises a processing component; the processing component is used to detect, when the 2(n+1) input lines are present and power supply normally, and the first input port and the second input port of the (n+1) power modules have the power supply input respectively, determining the power module assembly is in a normal power supply status.

17. The computing device according to claim 12, wherein the power module assembly is connected to 2n input lines one by one based on the 2n input connectors among the 2(n+1) input connectors to receive a power supply input from the power supply sources, and the load comprises a processing component; and the processing components are used to detect, when the 2n input lines are present and power supply normally, and the first input port and the second input port of (n-1) power modules among the (n+1) power modules have a power supply input respectively, and one input port of two power modules among the (n+1) power modules have the power supply input, determining the power module assembly is in a normal power supply status.

18. A server cabinet, comprising:
a cabinet body, a power module assembly, and a load; wherein the power module assembly and the load are installed in the cabinet body; and the cabinet body is connected to an external dual-input power supply source, the power module assembly is used for supplying power to the load based on a dual power supply input;
the power module assembly comprises (n+1) power modules and 2(n+1) input connectors: the input connectors used for connecting power supply sources and the power modules, each power module comprises a first input port and a second input port which are respectively connected to one input connector; wherein n is a positive integer;
based on positions of the 2(n+1) input connectors, when 2n input connectors among the 2(n+1) input connectors are connected to a power supply input of the power supply sources, and the (2a+1)th input connector and the (2a+2)th input connector among the 2(n+1) input connectors are not connected to the power supply input of the power supply sources, the (n+1) power modules among the power module assembly achieve power supply, wherein a represents a non-negative integer, and is less than or equal to n.
